# EUROPEAN PATENT APPLICATION

(11) **EP 2 415 833 A1**
(43) Date of publication of application: **08.02.2012**
(21) Application number: 10761568.4
(22) Date of filing: 16.03.2010
(51) Int. Cl.: C08L 27/12, C08K 5/5415, C08L 101/12, H01B 1/12, H01L 51/50

(54) **CONDUCTIVE POLYMER COMPOSITION, CONDUCTIVE CURED FILM, AND ORGANIC ELECTROLUMINESCENT ELEMENT**

(30) Priority: 30.03.2009 JP 2009083774
(71) Applicant: FUJIFILM Corporation, Tokyo 106-0031 (JP)
(72) Inventor: HAYASHI, Naoyuki, Ashigarakami-gun, Kanagawa (JP); KATO, Hisashi, Ashigarakami-gun, Kanagawa (JP); OKADA, Hisashi, Ashigarakami-gun, Kanagawa (JP)
(74) Representative: HOFFMANN EITLE
(86) International application number: PCT/JP2010/054447
(87) International publication number: WO 2010/116867

(57) **Abstract**

Provided is a conductive polymer composition capable of forming a conductive film that is highly resistant to organic solvents and can ensure excellent durability (i.e. a long lifespan of luminance half-life) of an electroluminescent device.

The conductive polymer composition includes (A) a conductive polymer, (B) a first polymer having a repeating unit represented by Formula (1) as indicated below and a repeating unit represented by Formula (II) as indicated below, or a second polymer having a repeating unit represented by Formula (I) as indicated below, a repeating unit represented by Formula (II) below and a repeating unit represented by Formula (II') as indicated below: 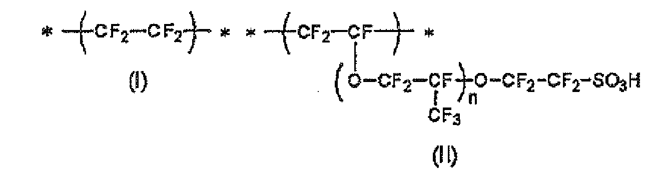 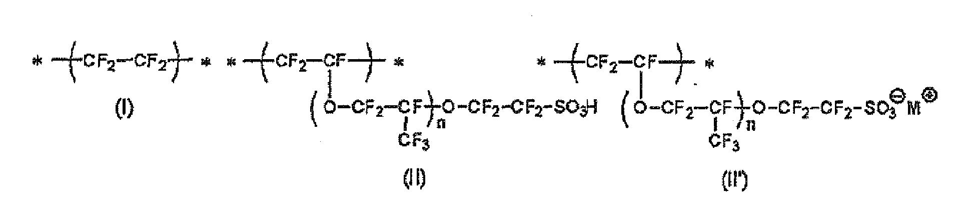 wherein M⁺ represents a monovalent cation and each n independently represents an integer, and (C) a curing agent.

## Description

### TECHNICAL FIELD

The present invention relates to a conductive polymer composition, a conductive cured film and an organic electroluminescence device.

### BACKGROUND ART

Research into devices using organic materials, such as organic electroluminescence devices (hereinafter, also referred to as "OLEDs") and transistors using organic semiconductors has been actively conducted. Organic electroluminescence devices are particularly promising as solid emission type large-area, full-color display devices and inexpensive large-area surface light sources for lighting applications. A general organic electroluminescence device includes an organic layer including a light-emitting layer and a pair of electrodes interposing the organic layer therebetween. When a voltage is applied to the organic electroluminescence device, electrons are injected into the organic layer from a cathode, and holes are injected into the organic layer from an anode. The electrons recombine with the holes in the light-emitting layer, and as a result, the energy level returns back to the valence band from the conduction band. At this time, the energy is emitted as light, achieving light emission.

Patent Document 1 describes an OLED having a hole injection layer between an anode and a light-emitting layer wherein the hole injection layer includes a conductive polymer, typified by poly(3,4-ethylenedioxythiophene)/poly(styrenesulfonate) (PEDOT/PSS), and a polymer (dopant) having acid groups. An aqueous dispersion of PEDOT/PSS is usually used as a coating solution for the formation of the hole injection layer taking into consideration the fact that the dopant PSS is highly hydrophilic.

### PRIOR ART DOCUMENTS

### PATENT DOCUMENT

Patent Document 1: Japanese Examined Patent Publication No. 2006-500463

### NON-PATENT DOCUMENT

Non-Patent Document 1: Organic Electronics, Vol.9, 869-872 (2008)

### SUMMARY OF THE INVENTION

### PROBLEMS TO BE SOLVED BY THE INVENTION

However, for example, a problem of the hole injection layer formed of an aqueous dispersion of PEDOT/PSS is (1) insufficient dehydration despite carrying out drying process or (2) decomposition of PSS to generate ions causing degradation of metal electrodes (see Non-Patent Document 1). Such a problem eventually leads to deteriorated durability (more specifically, short lifetime of luminance half-life) of an OLED.

Thus, techniques associated with the use of fluorinated polymers having acid groups (more specifically, Nafion (registered trademark)) as dopants have been proposed (see Patent Document 1).
Advantages of using such fluorinated polymers having acid groups are that (1) non-aqueous solvents, such as ethylene glycol and 2-n-butoxyethanol, can be used as media of coating solutions for hole injection layers to reduce the water content of the hole injection layers, and (2) the stable fluorinated polymers can be used.

However, despite the use of fluorinated polymers having acid groups as dopants, the durability of OLEDs including hole injection layers formed by coating still remains insufficient.

The present invention has been made in view of the problems of the related art and is intended to achieve the following objects.
That is, an object of the present invention is to provide a conductive polymer composition capable of forming a conductive film that is highly resistant to organic solvents and can ensure excellent durability (i.e. having a long lifetime of luminance half-life) of an electroluminescence device.
Another object of the present invention is to provide a conductive cured film that is highly resistant to organic solvents and can ensure excellent durability of an electroluminescence device.
Still another object of the present invention is to provide an organic electroluminescence device with excellent durability (i.e. having a long lifetime of luminance half-life).

### MEANS FOR SOLVING THE PROBLEMS

Under these circumstances, the present inventor has undertaken extensive studies, and as a result, has reached the following findings.
Specifically, the present inventor has found that when a coating solution containing a light-emitting material is applied to a hole injection layer having a conductive polymer and a fluorinated polymer having acid groups to form a light-emitting layer, selection of a highly polar solvent, such as N-methylpyrrolidone (NMP), or a halogen-based solvent, such as chloroform, in view of affinity for the light-emitting material, leads to dissolution of the constituent materials of the hole injection layer in the coating solution, resulting in deterioration of the hole injecting performance (i.e. conductivity) of the hole injection layer. Based on this finding, the present inventor has further reviewed and finally achieved the present invention.

The following are means for achieving the above objects.
(1) A conductive polymer composition having: (A) a conductive polymer; (B) a first polymer comprising a repeating unit represented by Formula (I) as indicated below and a repeating unit represented by Formula (II) as indicated below, or a second polymer comprising a repeating unit represented by Formula (I) as indicated below, a repeating unit represented by Formula (II) as indicated below and a repeating unit represented by Formula (II') as indicated below, and (C) a curing agent.

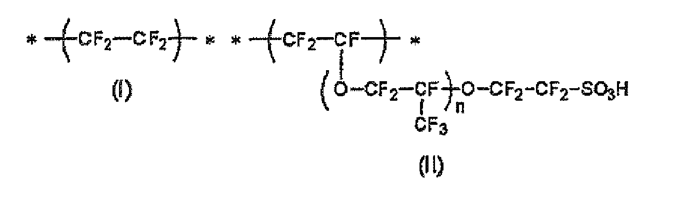

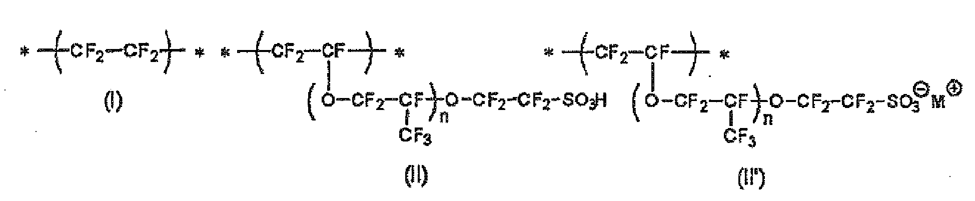

In the formula, M⁺ represents a monovalent cation and each n independently represents an integer.

(2) The conductive polymer composition according to (1), wherein the conductive polymer is a polymer or copolymer of one or more monomers selected from the group consisting of thiophene, thiophene derivatives, pyrrole and pyrrole derivatives.

(3) The conductive polymer composition according to (1) or (2), wherein the curing agent is a silicon compound represented by Si(R¹)₃(R²): wherein each R¹ independently represents a C₁-C₅ alkoxy group and R² represents a monovalent hydrophobic group.

(4) The conductive polymer composition according to (1) or (2), wherein the curing agent is a polyhydric alcohol.

(5) The conductive polymer composition according to any one of (1) to (4), further having (D) a solvent.

(6) The conductive polymer composition according to (5), wherein the solvent is a non-aqueous solvent.

(7) The conductive polymer composition according to (6), wherein the non-aqueous solvent is pretreated with dehydration or column purification.

(8) A conductive cured film obtained by applying curing energy to a film of the conductive polymer composition according to any one of (1) to (7).

(9) An organic electroluminescence device having one or more organic layers wherein one of the organic layers is the conductive cured film according to (8).

(10) The organic electroluminescence device according to (9), wherein one of the organic layers is a hole injection layer.

### EFFECTS OF THE INVENTION

The present invention can provide a conductive polymer composition capable of forming a conductive film that is highly resistant to organic solvents and can ensure excellent durability (i.e. having a long lifetime of luminance half-life) of an electroluminescent device.
In addition, the present invention can provide a conductive cured film that is highly resistant to organic solvents and can ensure excellent durability of an electroluminescent device.
Furthermore, the present invention can provide an organic electroluminescence device with excellent durability (i.e. having a long lifespan of luminance half-life).

### BRIEF DESCRIPTION OF THE DRAWINGS

Fig. 1 is a schematic cross-sectional view illustrating an electroluminescent device according to an embodiment of the present invention.
Fig. 2 shows changes in the contents of Ir and F elements in a hole injection layer and a light-emitting layer of an organic electroluminescence device fabricated in Example 5 in the thickness directions of the layers.
Fig. 3 shows changes in the contents of Ir and F elements in a hole injection layer and a light-emitting layer of an organic electroluminescence device fabricated in Comparative Example 3 in the thickness directions of the layers.

### DETAINED DESCRIPTION FOR CARRYING OUT THE INVENTION

The present invention will now be described in detail. A numerical range represented by "to" in the specification represents a range including numerical values described in front of and behind "to" as the minimum value and the maximum value, respectively.

The present invention provides a conductive polymer composition including (A) a conductive polymer, (B) a first polymer having a repeating unit represented by Formula (I) and a repeating unit represented by Formula (II), or a second polymer having a repeating unit represented by Formula (I), a repeating unit represented by Formula (II) and a repeating unit represented by Formula (II') (hereinafter, the component (B) is also referred to as an "acid polymer"), and (C) a curing agent.

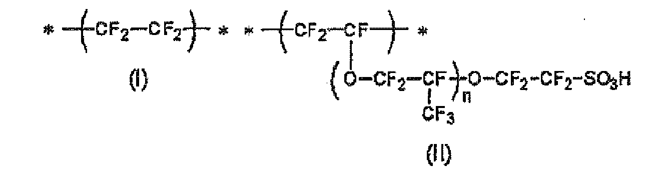

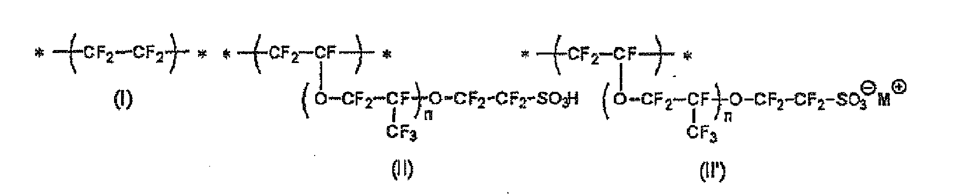

In the formula, M⁺ represents a monovalent cation and each n independently represents an integer.

Hereinafter, a description will be given concerning the respective components of the conductive polymer composition according to the present invention.

### <(A) Conductive Polymer>

The conductive polymer may be any one of those known in the art, but is preferably a polymer or copolymer of one or more monomers selected from the group consisting of thiophene, thiophene derivatives, pyrrole and pyrrole derivatives. For example, the polymer or copolymer may be a thiophene polymer (polythiophene), a polymer of a thiophene derivative, a pyrrole polymer (polypyrrole), a polymer of a pyrrole derivative, a copolymer of thiophene and a thiophene derivative, a copolymer of pyrrole and a pyrrole derivative, or a copolymer of thiophene or a thiophene derivative and pyrrole or a pyrrole derivative.

Examples of the thiophene derivatives include 3,4-ethylenedioxythiaphene, 3,4-vinylenedioxythiophene, 3-alkylthiophene, 3-phenylthiophene and isothianaphthen.

The thiophene and thiophene derivatives as the monomers for the polymer or copolymer are more preferably 3,4-ethylenedioxythiophene and 3-hexylthiophene, even more preferably 3,4-ethylenedioxythiophene.

Examples of the pyrrole derivatives include 3,4-akylpyrrole, 1-alkylpyrrole, 3-alkylpyrrole, 3,4-ethylcnedioxypyrrole and 3,4-propylenedioxypyrrole.

The pyrrole and pyrrole derivatives as the monomer for the polymer or copolymer are more preferably pyrrole and 3-alkylpyrrole, even more preferably pyrrole.

In the case where the conductive polymer is a copolymer, the molar ratio of the repeating units is not particularly limited and is appropriately determined according to the intended application of the conductive polymer composition.

The conductive polymer is particularly preferably poly(3,4-ethylenedioxythiophene).

The conductive polymer is preferably present in an amount of 10 to 50% by mass, more preferably 10 to 40% by mass, based on the total solids content of the conductive polymer composition.
The conductive polymer composition forms a film having conductivity ranging from 10⁻⁶ to 10⁰ S/cm, preferably from 10⁻⁴ to 10⁻² S/cm.

### <(B) Acid Polymer>

The acid polymer used in the conductive polymer composition of the present invention is a first polymer having a repeating unit represented by Formula (I) (hereinafter, also referred to simply as "repeating unit (I)") and a repeating unit represented by Formula (II) (hereinafter, also referred to simply as "repeating unit (II)"), or a second polymer having a repeating unit represented by Formula (I), a repeating unit represented by Formula (II) (hereinafter, also referred to simply as "repeating unit (II)") and a repeating unit represented by Formula (II') (hereinafter, also referred to simply as "repeating unit (II')").

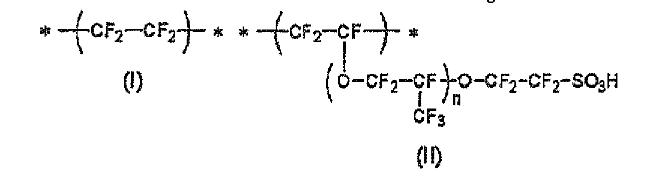

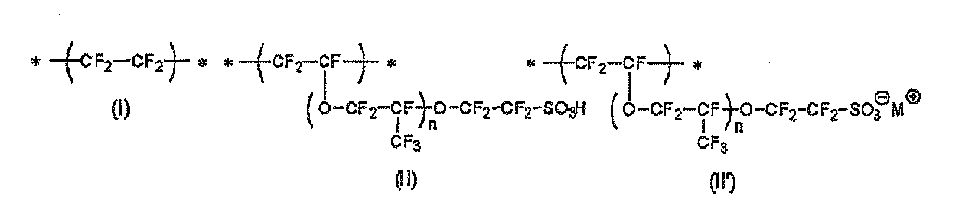

In the formula, M⁺ represents a monovalent cation and each of n independently represents an integer. Typically, n represents an integer from 100 to 100,000. The monovalent cation M⁺ may be, for example, a sodium or potassium ion.

The second polymer is preferably prepared, for example, by acid-base reaction of the sulfonic acid groups of some of the repeating units (II) constituting the first polymer with an alkali compound capable of providing the cation M⁺.

The molar ratio of the repeating unit (I) to the repeating unit (II) in the first polymer and the molar ratio of the repeating unit (I) to the sum of the repeating units (II) and (II') in the second polymer are not particularly limited, but are each preferably from 1:100 to 1:3,000, more preferably from 5:2,000 to 13:2,000.

The molar ratio of the repeating unit (II) to the repeating unit (II') in the second polymer is not particularly limited and is appropriately determined so long as the effects of the present invention are not impaired.

The acid polymer is more preferably the first polymer not including the repeating unit (II').

The acid polymer can be synthesized by the methods described, for example, in PCT International Publication No. WO 98/31716 and U.S. Patent No. 4,940,525 and is also commercially available from DuPont under the trademarks Nafion (registered trademark) DE521, DE520, DE1020, DE1021, DE2020 and DE2021.

The first polymer may contain any suitable repeating unit (except for the repeating unit (II')) other than the repeating units (I) and (II) so long as the effects of the present invention are not impaired.
The second polymer may contain any suitable repeating unit other than the repeating units (I), (II) and (II') so long as the effects of the present invention are not impaired.

The acid polymer is preferably present in an amount of 20 to 90% by mass, more preferably 40 to 70% by mass, based on the total solids content of the conductive polymer composition.

The conductive polymer composition is preferably prepared by polymerization of the monomers for the conductive polymer in the presence of the acid polymer. For example, the conductive polymer composition may be obtained in a state of an aqueous dispersion, based on the methods described in Japanese Patent Application Laid-Open No. Hei 7-90060 and Japanese Patent Publication No. 2006-500463.

### <(C) Curing Agent>

Any curing agent that can absorb the quantity of energy sufficient to cure the solids of the conductive polymer composition may be used without particular limitation. Examples of preferred curing agents include silane coupling agents and polyhydric alcohols known in the art.

The curing energy is not specifically limited so long as it induces a curing reaction and may be, for example, thermal energy or light energy (including UV energy).

For example, in the case where a silane coupling agent is used as the curing agent, thermal energy may be selected as the curing energy. In this case, heating of the solids (for example, a solid film) of the conductive polymer composition causes coupling between the molecules of the silane coupling agent, and as a result, the solid film is further cured to form a cured film.

In the case where a polyhydric alcohol is used as the curing agent, thermal energy may be also selected as the curing energy. In this case, heating of the solids (for example, a solid film) of the conductive polymer composition causes cross-linking between the hydroxyl groups of the polyhydric alcohol and the acid groups (sulfonic acid groups) of the acid polymer, and as a result, the solid film is further cured to form a cured film.

All known methods may be employed to impart thermal energy to the conductive polymer composition and are suitably selected depending on the type of the reactions. For example, the conductive polymer composition may be heated on a hot plate or in an oven at 80 to 200 °C for 5 min to 1 hr.

The silane coupling agent is preferably a silicon compound represented by Si(R¹)₃(R²) (wherein each of R¹ independently represents a C₁-C₅ alkoxy group and R² represents a monovalent hydrophobic group).

The C₁-C₅ alkoxy group as R¹ is preferably a methoy, ethoxy, propoxy or butoxy group, more preferably a methoy or ethoxy group.

The monovalent hydrophobic group as R² is preferably a group containing at least one group or atom selected from alkyl groups, aryl groups, glycidyl groups, perfluoroalkyl groups and fluorine atoms. The monovalent hydrophobic group may be, for example, a methyl, ethyl, propyl, 3-glycidoxypropyl, phenethyl, benzyl or phenyl group.
The introduction of the hydrophobic group into the silane coupling agent increases the compatibility of the silane coupling agent with the acid polymer (fluorinated polymer), so that a desired cured film can be more surely obtained.

Specifically, as the silicon compound represented by Si(R¹)₃(R²), there can be mentioned, for example, phenethyltrialkoxysilane, phenyltrialkoxysilane, benzyltrialkoxysilane, ethyltrialkoxysilane, hexyltrialkoxysilane, trifluoropropyltrialkoxysilane, 1H, 1H,2H,2H-tridecafluoro-n-octyltrialkoxysilane, 1H,1H,2H,2H-perfluorodecyltrialkoxysilane,3-glycidoxypropyltrialkoxysilane or2-(3,4-epoxycyclohexyl)ethyltrimethoxysilane. Phenethyltrialkoxysilane, ethyltrialkoxysilane or 3-glycidoxypropyltrialkoxysilane is more preferred.

The use of the silicon compound represented by Si(R¹)₃(R²) can further decrease the risk of formation of cracks in a cured film when compared to the use of a silicon compound represented by Si(R¹)₄.
In addition, the use of the silicon compound represented by Si(R¹)₃(R²) enables the formation of a sufficiently strong cured film when compared to the use of a silicon compound represented by Si(R¹)₂(R₂)₂.

The polyhydric alcohol may be, for example, polyvinyl alcohol or polyhydroxyacrylate. The degrees of polymerization of the polyvinyl alcohol and polyhydroxyacrylate are preferably from 200 to 3,000.

The curing agent is preferably present in an amount of 0.05 to 20% by mass, more preferably from 0.1 to 15% by mass, based on the total solids content of the conductive polymer composition.
In a case where the curing agent is the silane coupling agent, the silane coupling agent is preferably present in an amount of 0.1 to 5% by mass, more preferably from 0.1 to 1% by mass, based on the total solids content of the conductive polymer composition.
In a case where the curing agent is the polyhydric alcohol, the polyhydric alcohol is preferably present in an amount of 5 to 15% by mass, more preferably from 10 to 15% by mass, based on the total solids content of the conductive polymer composition.

### <Other Components>

The conductive polymer composition of the present invention may further include one or more additives and coating stabilizing materials. Examples of additives and coating stabilizing materials suitable for use in the conductive polymer composition include stabilizers, viscosity modifiers, anti-aging agents, pH adjusting agents, antiseptic agents, resin emulsions and leveling agents.

The viscosity of the conductive polymer composition of the present invention is appropriately determined according to intended applications. In a case where the conductive polymer composition is used to form an organic layer of an OLED, the viscosity of the conductive polymer composition is preferably in the range of 1 mPa·s to 50 mPa·s, more preferably in the range of 2 mPa·s to 10 mPa·s.

The conductive polymer composition of the present invention has a surface tension ranging from 20 mN/m to 70 mN/m, preferably from 25 mN/m to 40 mN/m. Within this range, a smooth coating film can be formed without irregularity or non-uniformity.

Particularly, when it is desired to form an organic layer of an OLED, it is preferred that the conductive polymer composition of the present invention falls within the viscosity and surface tension ranges defined above. It is also preferred that the conductive polymer composition of the present invention meets any combination of two or more characteristics and further meet all characteristics. This makes the conductive polymer composition suitable for coating.

Accordingly, it is preferred that the conductive polymer composition of the present invention further includes (D) a solvent to allow the viscosity and/or surface tension of the conductive polymer composition to fall within the ranges defined above. For example, the solvent may be at least one selected from the group consisting of: aqueous solvents, such as water; non-aqueous solvents, such as methanol, ethanol, n-propanol, isopropanol, ethylene glycol, diethylene glycol and glycerin. It is preferred to determine whether to select an aqueous solvent or a non-aqueous solvent by taking into consideration the ability to dissolve or disperse the conductive polymer (A), the acid polymer (B) and the curing agent (C).
For example, in the case where polyvinyl alcohol described above is used as the curing agent, as exemplified above, an aqueous solvent, such as water, is preferably selected in order to obtain a good dispersion state.

Also, in a case where the conductive polymer (A), the acid polymer (B) and the curing agent (C) can be good dissolved or dispersed, a non-aqueous solvent is preferably selected. The reason for this selection is that the water content of a cured film to be obtained can be low compared to the case using an aqueous solvent because the non-aqueous solvent is not used. As a result, an organic electroluminescence device (for example, an OLED) using the cured film as an organic layer (for example, a hole injection layer) has high durability (i.e. having a long lifetime of luminance half life).

For example, in a case where the silicon compound represented by Si(R¹)₃(R²) is used as the curing agent, it is preferred to use a non-aqueous solvent as the solvent of the conductive polymer composition.

According to the above described reason, it is more preferred that the non-aqueous solvent may be a high-purity solvent having undergone dehydration or column purification known in the art because it is preferable that the water content of the non-aqueous solvent is the lowest possible level.

In view of the above explanation, the conductive polymer composition of the present invention uses a fluorinated polymer as the acid polymer. The use of the fluorinated polymer can low the water absorption or retention of a formed film and enables the formation of a conductive film that can ensure excellent durability (i.e. having a long lifetime of luminance half-life) of an electroluminescent device.
A cured film formed by applying curing energy to a solid film formed by using the conductive polymer composition of the present invention has highly resistant to organic solvents and high electrically conductive because the constituent materials of the cured film become me firmly trapped, for example, inside a three-dimensional mesh structure formed by the curing reaction of the curing agent. Accordingly, the risk that when a coating solution for an organic layer (for example, for a light-emitting layer of an OLED) is applied to the conductive film (for example, as a hole injection layer of an OLED), the constituent materials of the conductive film may be dissolved in the coating solution can be reduced. Further, the coating solution can be applied in a desired state because the underlying conductive film is hard and stabilized after curing. For these reasons, the conductive film can be used to fabricate a high-performance (particularly, a high-durability) electroluminescent device.

The present invention also provides a conductive cured film formed using the conductive polymer composition. Specifically, the conductive cured film is obtained by applying curing energy to a film of the conductive polymer composition. The conductive cured film of the present invention has high resistance to organic solvents and can ensure excellent durability of an electroluminescent device.

### <Organic electroluminescence device>

Hereinafter, a description will be given concerning the organic electroluminescence device of the present invention.
The organic electroluminescence device of the present invention has at least one organic layer, typically, between a pair of electrodes. The organic layer includes a light-emitting layer. The light-emitting layer preferably contains a phosphorescent compound. The organic layer may further have at least one layer selected from organic layers, protective layers and sealing layers, if needed, in addition to the light-emitting layer.
The conductive cured film of the present invention constitutes one of the organic layers, making the organic electroluminescence device highly durable (i.e. having a long lifetime of luminance half-life).

Examples of organic layers that can be formed using the conductive polymer composition of the present invention include light-emitting layers, hole injection layers, hole transporting layers, electron injecting layers, and electron transporting layers. The conductive polymer composition of the present invention may be used to form one or more of the organic layers. Preferably, the conductive polymer composition of the present invention is applied to a hole injection layer.

Preferably, oxygen is present at a lower concentration in the device. The concentration of oxygen in the device may be 100 ppm or lower, and preferably be 50 ppm or lower. No particular limitation is imposed on a method for creating an atmosphere containing oxygen at a concentration not higher than 100 ppm. For example, the device may be sealed in an inert gas atmosphere containing oxygen at a concentration not higher than 100 ppm. The inert gas is preferably nitrogen, argon, etc. in terms of price and ease of handling.

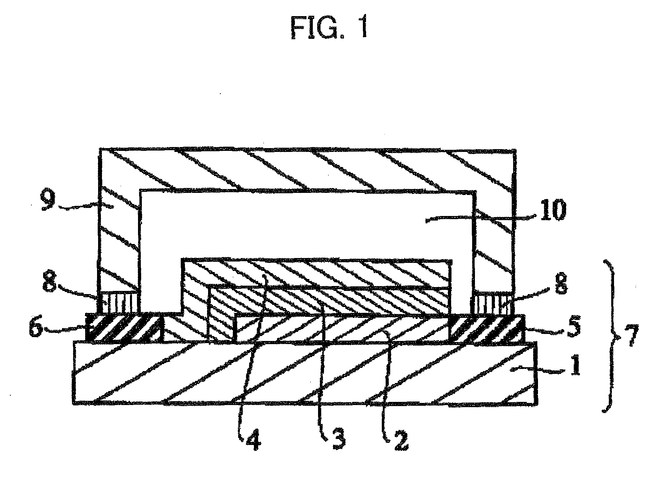

Fig. 1 is a schematic cross-sectional view illustrating an organic electroluminescence device according to an embodiment of the present invention. The electroluminescence device illustrated in Fig. 1 has a light-emitting laminate 7 having a transparent electrode 2, an organic compound layer 3 and a back electrode 4 formed on a substrate 1, and a sealing member 9 to seal the organic compound layer 3. In this embodiment, the sealing member 9 is adhered to the substrate 1, a transparent electrode lead 5 and a back electrode lead 6 by means of a sealant (adhesive) 8 and is disposed on the light-emitting laminate 7. A moisture absorbent or an inert liquid may be injected into a space 10. Examples of the moisture absorbent includes, but not particularly limited to, barium oxide, sodium oxide, potassium oxide, calcium oxide, sodium sulfate, calcium sulfate, magnesium sulfate, phosphorus pentoxide, calcium chloride, magnesium chloride, copper chloride, cesium fluoride, niobium fluoride, calcium bromide, vanadium bromide, molecular sieves, zeolite and magnesium oxide. Examples of usable inert liquids include paraffins, liquid paraffins, fluorinated solvents (for example, perfluoroalkanes, perfluoroamines and perfluoroethers), chlorinated solvents and silicone oils.

For example, the light-emitting laminate of the organic electroluminescence device according to the present invention may have a structure of: transparent electrodeflight-emitting layer/back electrode, transparent electrode/light-emitting layer/electron injection layer/back electrode; transparent electrode/hole injection layer/light-emitting layer/electron injection layer/back electrode; transparent electrode/hole injection layer/light-emitting layer/back electrode; transparent electrode/light-emitting layer/electron transporting layer/electron injection layer/back electrode; or transparent electrode/hole injection layer/hole transporting layer/light-emitting layer/electron transporting layer/electron injection layer/back electrode laminated in this order or a reverse order on a substrate. The light-emitting layer contains a phosphorescent compound and light is normally outputted from the transparent electrode. Details of compounds used in the respective layers are presented, for example, in "Organic EL Displays" (Technotimes), a separate volume of "Monthly Display," the October issue of 1998.

Although the organic compound layer may be formed in any position without particular limitation, and the position of the organic compound layer may be appropriately selected according to the intended application and purpose of the electroluminescence device, it is preferred to form the organic compound layer on the transparent electrode or the back electrode. The organic compound layer may be formed over the entire surface of the transparent electrode or the back electrode or on a portion of the surface of the transparent electrode or the back electrode. The shape, size and thickness of the organic compound layer may be appropriately selected according to the intended purpose.

While it is preferred to form one of the organic layers using the conductive polymer composition of the present invention by a wet process, the other layers may be formed by a dry process, a wet process or a combination thereof. The use of a wet process is preferred in that the organic layer can be easily formed on a large area and the electrolumixrescence device can be fabricated with high luminance intensity and luminescence efficiency in an economical and efficient manner. Examples of suitable dry processes include deposition and sputtering. Examples of suitable wet processes include dipping, spin coating, dip coating, casting, die coating, roll coating, bar coating, gravure coating, spray coating and ink jetting. These processes can be appropriately selected according to the kind of materials for the organic layer. Drying may follow the wet process after film formation. Drying is performed under suitable conditions. For example, drying temperature and pressure conditions are appropriately selected such that the coating layer is not damaged.

A coating solution used for the wet process (coating process) is commonly composed of a material for the organic compound layer and a solvent for dissolving or dispersing the material. The solvent is not particularly limited and is selected depending on the material for the organic compound layer. Specific examples of solvents suitable for use in the coating solution include halogen-based solvents (for example, chloroform, carbon tetrachloride, dichloromethane, 1,2-dichloroethane and chlorobenzene), ketone-based solvents (for example, acetone, methyl ethyl ketone, diethyl ketone, n-propyl methyl ketone and cyclohexanone), aromatic solvents (for example, benzene, toluene and xylene), ester-based solvents (for example, ethyl acetate, n-propyl acetate, n-butyl acetate, methyl propionate, ethyl propionate, γ-butyrolactone and diethyl carbonate), ether-based solvents (for example, tetrahydrofuran and dioxane), amide-based solvents (for example, dimethylformamide and dimethylacetamide), dimethyl sulfoxide, and water. The solids content of the coating solution is not particularly limited and the viscosity of the coating solution may be arbitrarily selected according to the process type.

The organic electroluminescence device of the present invention usually emits light when a direct current voltage (which may include an alternating current component) of about 2 to about 40 V or a direct current is applied between the transparent electrode and the back electrode. The electroluminescence device of the present invention may be driven by the methods described, for example, in Japanese Unexamined Patent Publication Nos. Hei 2-148687, Hei 6-301355, Hei 5-29080, Hei 7-134558, Hei 8-234685 and Hei 8-241047, U.S. Patent Nos. 5828429, and 6023308, and Japanese Patent No. 2784615. A detailed explanation will be given concerning the constituent layers of the light-emitting laminate, but the present invention is not limited thereto.

### (A) Substrate

The substrate is preferably made of a material which is impermeable or substantially impermeable to moisture. Preferably, the material does not scatter or attenuate light emitted from the organic layer. Specific examples of suitable materials for the substrate include: inorganic materials, such as yttria-stabilized zirconia (YSZ) and glass; polyesters, such as polyethylene terephthalate, polybutylene terephthalate and polyethylene naphthalate; and organic materials, such as polystyrene, polycarbonate, polyethersulfone, polyarylate, allyl diglycol carbonate, polyimide, polycycloolefin, norbornene resins and poly(chlorotrifluoroethylene). Of these, the organic materials are particularly preferred due to their good heat resistance, dimensional stability, solvent resistance, electrical insulation and processability, low air-permeability and low moisture absorptivity. The substrate materials may be used either singly or in combination of two or more thereof. The substrate material can be suitably selected depending on a material for the transparent electrode. For example, in the case where the transparent electrode is made of indium tin oxide (ITO), it is preferred that the substrate is made of a material whose lattice constant is close to that of ITO.

The shape, structure, size, etc. of the substrate can be suitably selected according to the intended application and purpose of the electroluminescence device. The substrate is generally plate-like in shape. The substrate may have a monolayer or laminated structure. The substrate may be colorless or colored transparent but is preferably a colorless transparent one in that light emitted from the light-emitting layer is not scattered or attenuated.

A moisture permeation-preventing layer (gas barrier layer) may be formed on the surface of the substrate toward or opposite to the electrodes. Alternatively, moisture permeation-preventing layers may be formed on both surfaces of the substrate. The moisture permeation-preventing layer is preferably formed of an inorganic material such as silicon nitride or silicon oxide. The moisture permeation-preventing layer can be formed by radio-frequency sputtering. If necessary, a hard coating layer or an undercoating layer may be forked on the substrate.

### (B) Transparent electrode

Generally, the transparent electrode functions as an anode for supplying holes to the organic compound layer. Alternatively, the transparent electrode may function as a cathode. In this case, the back electrode functions as an anode. The transparent electrode functioning as an anode will be explained below.

The shape, structure, size, etc. of the transparent electrode can be suitably selected without particular limitation according to the intended application and purpose of the electroluminescence device. The transparent electrode may be made of, for example, a metal, an alloy, a metal oxide, an electrically conductive compound, or a mixture thereof. The material for the transparent electrode preferably has a work function of at least 4 eV. Specific examples of suitable materials for the transparent electrode include antimony-doped tin oxide (ATO), fluorine-doped tin oxide (FTO), semiconductive metal oxides (for example, tin oxide, zinc oxide, indium oxide, indium tin oxide (ITO) and indium zinc oxide (IZO)), metals (for example, gold, silver, chromium and nickel), mixtures and laminates of the metals and the conductive metal oxides, inorganic conductive materials (for example, copper iodide and copper sulfide), organic conductive materials (for example, polyaniline, polythiophene and polypyrrole), and laminates of the organic conductive materials and ITO.

The transparent electrode may be formed on the substrate by any suitable process, for example: a wet process, such as printing or coating; a physical process, such as vacuum deposition, sputtering or ion plating; or a chemical process, such as CVD or plasma CVD. A suitable process for forming the transparent electrode may be selected taking into consideration its suitability for the transparent electrode material. For example, in the case where ITO is used as a material for the transparent electrode, DC or radio-frequency sputtering, vacuum deposition, ion plating, etc. may be used. Alternatively, in the case where an organic conductive material is used as a material for the transparent electrode, a wet process may be used.

The transparent electrode may be patterned by any suitable process, for example, chemical etching such as photolithography, or physical etching such as laser etching. The patterning may also be performed by vacuum deposition or sputtering using a mask, lift off, printing, etc.

The position of the transparent electrode may be appropriately selected according to the intended application and purpose of the electroluminescence device. It is preferred to form the transparent electrode on the substrate. The transparent electrode may be formed over the entire surface of the substrate or on a portion of the surface of the substrate.

The thickness of the transparent electrode may be suitably selected according to the material for the transparent electrode and is typically from 10 nm to 50 µm, preferably from 50 nm to 20 µm. The resistance of the transparent electrode is preferably limited to 10² Ω/□ (Ω/square) or below, more preferably to 10 Ω/□ or below. The transparent electrode may be colorless or colored transparent. The transparent electrode preferably has a transmittance of 60% or more, more preferably 70% or more, which allows light to emit from the transparent electrode. The transmittance of the transparent electrode can be measured by a known method using a spectrophotometer.

Electrodes described in detail in "Development of Transparent Conductive Films" (Supervised by Yutaka Sawada, published by CMC Publishing Co., Ltd., 1999) can also be applied to the present invention. Particularly, in the case where a plastic substrate having low heat resistance is used, it is preferred to form the transparent electrode using ITO or IZO at a temperature of 150 °C or lower.

### (C) Back electrode

Generally, the back electrode functions as a cathode for injecting electrons into the organic layer. Alternatively, the back electrode may function as an anode. In this case, the transparent electrode functions as a cathode. The back electrode functioning as a cathode will be explained below.

The shape, structure, size, etc. of the back electrode can be suitably selected without particular limitation according to the intended application and purpose of the electroluminescence device. The back electrode may be made of, for example, a metal, an alloy, a metal oxide, an electrically conductive compound, or a mixture thereof. The material for the back electrode preferably has a work function of 4.5 eV or less. Specific examples of suitable materials for the back electrode include alkali metals (for example, Li, Na, K and Cs), alkaline-earth metals (for example, Mg and Ca), gold, silver, lead, aluminum, sodium-potassium alloys, lithium-aluminum alloys, magnesium-silver alloys, indium, and rare earth metals (for example, ytterbium). These materials may be used alone but, preferably, are used in combination of two or more thereof in terms of both stability and electron injectability. Of these materials, alkali metals and alkaline-earth metals are preferred in terms of electron injectability, and aluminum-based materials are preferred in terms of storage stability. The term "aluminum-based materials" is intended to include aluminum as well as aluminum alloys containing 0.01 to 10% by weight of an alkali metal, an alkaline-earth metal or a mixture (for example, lithium-aluminum alloys and magnesium-aluminum alloys). The materials described in detail, for example, in Japanese Unexamined Patent Publication Nos. Hei 2-15595 and Hei 5-121172 can also be used for the back electrode.

The back electrode may be formed by any suitable process, for example: a wet process, such as printing or coating; a physical process, such as vacuum deposition, sputtering or ion plating; or a chemical process, such as CVD or plasma CVD. A suitable process for forming the back electrode may be selected taking into consideration its suitability for the back electrode material. For examples, two or more kinds of metals may be used to form the back electrode. In this case, the materials may be sputtered simultaneously or sequentially.

The back electrode may be patterned by any suitable process, for example, chemical etching such as photolithography, or physical etching such as laser etching. The patterning may also be performed by vacuum deposition or sputtering using a mask, lift off, printing, etc.

The position of the back electrode may be appropriately selected according to the intended application and purpose of the electroluminescence device. It is preferred to form the back electrode on the organic compound layer. The back electrode may be formed over the entire surface of the organic compound layer or on a portion of the surface of the organic compound layer. A dielectric layer may be formed between the back electrode and the organic compound layer. The dielectric layer may be formed of an alkali metal or alkaline-earth metal fluoride and may have a thickness of 0.1 to 5 nm. The dielectric layer may be formed by a suitable process, such as vacuum deposition, sputtering or ion plating.

The thickness of the back electrode may be suitably selected according to the material for the back electrode and is typically from 10 nm to 5 µm, preferably from 50 nm to 1 µm. The back electrode may be transparent or opaque. The transparent back electrode may be formed by forming a layer of the above-mentioned material to a thickness of 1 to 10 nm and laminating a layer of a transparent conductive material, such as ITO or IZO, thereon.

### (D) Light-emitting Layer

Preferably, the light-emitting layer of the electroluminescent device according to the present invention contains a phosphorescent compound. Any phosphorescent compound capable of emitting light from triplet excitons may be used without particular limitation in the present invention. The phosphorescent compound is preferably an ortho-metallized complex or a porphyrin complex, more preferably an ortho-metallized complex. The porphyrin complex is preferably a porphyrin platinum complex. The phosphorescent compound may be used alone or in combination with one or two other phosphorescent compounds.

The term "ortho-metallized complex" used in the present invention is a generic name of a group of compounds described, for example, in Akio Yamamoto, "Organometallic Chemistry, Foundations and Applications," pp. 150-232, Shokabo (1982), and H. Yersin, "Photochemistry and Photophysics of Coordination Compounds," pp. 71-77 and pp. 135-146, Springer-Verlag (1987).
The ligand of the ortho-metallized complex is not particularly limited, but is preferably selected from 2-phenylpyridine derivatives, 7,8-benzoquinoline derivatives, 2-(2-thienyl)pyridine derivatives, 2-(1-naphthyl)pyridine derivatives and 2-phenylquinoline derivatives. These derivatives may have one or more substituents. The ortho-metallized complexes may have ligands other than their essential ligands. Any transition metal may be used as a center metal of the ortho-metallized complex. Examples of center metals suitable for use in the present invention include rhodium, platinum, gold, iridium, ruthenium and palladium. Of these, iridium is particularly preferred. The organic layer has high luminance and luminescence efficiency due to the presence of the ortho-metallized complex. Details of ortho-metallized complexes are also found in Paragraphs 0152-0180 of Japanese Patent Application No. 2000-254171.

The ortho-metallized complex used in the present invention can be synthesized by the known methods described, for example, in Inorg. Chem., 30, 1685, 1991, Inorg. Chem., 27, 3464, 1988, Inorg. Chem., 33, 545, 1994, Inorg. Chim. Acta, 181, 245, 1991, J. Organomet. Chem., 335, 293, 1987, and J. Am. Chem. Soc., 107, 1431, 1985.

The content of the phosphorescent compound in the light-emitting layer is, for example, from 0.1 to 70% by mass, preferably from 1 to 20% by mass, but is not particularly limited thereto. When the phosphorescent compound is present in an amount of less than 0.1 % by mass or exceeding 70% by mass, effects thereof may be insufficiently exhibited.

If necessary, the light-emitting layer may further contain a host compound, a hole injecting material, an electron injecting material, an electrically inactive polymer binder, etc.

The host compound refers to a compound that allows the phosphorescent compound to emit light as a result of energy transfer from its excited state to the phosphorescent compound. Examples of such host compounds include carbazole derivatives, triazole derivatives, oxazole derivatives, oxadiazole derivatives, imidazole derivatives, polyarylalkane derivatives, pyrazoline derivatives, pyrazolone derivatives, phenylenediamine derivatives, arylamine derivatives, amino-substituted chalcone derivatives, styrylanthracene derivatives, fluorenone derivatives, hydrazone derivatives, stilbene derivatives, silazane derivatives, aromatic tertiary amine compounds, styrylamine compounds, aromatic dimethylidene compounds, porphyrin compounds, anthraquinodimethane derivatives, anthrone derivatives, diphenylquinone derivatives, thiopyran dioxide derivatives, carbodiimide derivatives, fluorenylidenemethane derivatives, distyrylpyrazine derivatives, anhydrides derived from heterocyclic tetracarboxylic acids having skeleton structures such as naphthalene and perylene, phthalocyanine derivatives, metal complexes of 8-quinolinol derivatives, metallophthalocyanines, metal complexes containing benzoxazole and benzothiazole ligands, polysilane compounds, poly(N-vinylcarbazole) derivatives, aniline copolymers, thiophene oligmers, conductive polymers such as polythiophene, polythiophene derivatives, polyphenylene derivatives, polyphenylenevinylene derivatives, and polyfluorene derivatives. These host compounds may be used alone or in combination of two or more thereof.

There is no particular restriction on the kind of the hole injecting material unless the hole injecting material has the ability to inject holes from an anode, transport holes and block electrons injected from a cathode. The hole injecting material may have a low or high molecular weight. Specific examples of the hole injecting materials suitable for use in the present invention include carbazole derivatives, triazole derivatives, oxazole derivatives, oxadiazole derivatives, imidazole derivatives, polyarylalkane derivatives, pyrazoline derivatives, pyrazolone derivatives, phenylenediamine derivatives, arylamine derivatives, amino-substituted chalcone derivatives, styrylanthracene derivatives, fluorenone derivatives, hydrazone derivatives, stilbene derivatives, silazane derivatives, aromatic tertiary amine compounds, styrylamine compounds, aromatic dimethylidene compounds, porphyrin compounds, polysilane compounds, poly(N-vinylcarbazole) derivatives, aniline copolymers, thiophene oligmers, conductive polymers such as polythiophene, polythiophene derivatives, polyphenylene derivatives, polyphenylenevinylene derivatives, and polyfluorene derivatives. These hole injecting materials may be used alone or as a mixture of two or more thereof.

There is no particular restriction on the kind of the electron injecting material unless the electron material has the ability to inject electrons from a cathode, transport electrons and block holes injected from an anode. Specific examples of the electron injecting materials suitable for use in the present invention include triazole derivatives, oxazole derivatives, oxadiazole derivatives, fluorenone derivatives, anthraquinodimethane derivatives, anthrone derivatives, diphenylquinone derivatives, thiopyran dioxide derivatives, carbodiimide derivatives, fluorenylidenemethane derivatives, distyrylpyrazine derivatives, heterocyclic tetracarboxylic anhydrides of aromatic rings such as naphthalene and perylene, phthalacyanine derivatives, metal complexes of 8-quinolinol derivatives, metallophthalocyanines, metal complexes containing benzoxazole and benzothiazole ligands, aniline copolymers, thiophene oligmers, conductive polymers such as polythiophene, polythiophene derivatives, polyphenylene derivatives, polyphenylenevinylene derivatives, and polyfluorene derivatives.

Examples of polymer binders suitable for use in the present invention include polyvinyl chloride, polycarbonate, polystyrene, polymethyl methacrylate, polybutyl methacrylate, polyester, polysulfone, polyphenylene oxide, polybutadiene, hydrocarbon resins, ketone resins, phenoxy resins, polyamide, ethyl cellulose, vinyl acetate, ABS resins, polyurethane, melamine resins, unsaturated polyester, alkyd resins, epoxy resins, silicone resins, polyvinyl butyral, and polyvinyl acetal. The presence of the polymer binder enables the formation of the light-emitting layer on a large area by a wet coating process.

The thickness of the light-emitting layer is preferably from 10 to 200 nm, more preferably from 20 to 80 nm. If the light-emitting layer is thicker than 200 nm, a driving voltage rise may occur. Meanwhile, if the light-emitting layer is thinner than 10 nm, short-circuiting in the electroluminescent device may be caused.

### (E) Electron Injection Layer

If necessary, the electroluminescent device of the present invention may have an electron injection layer formed of the electron injecting material described above. The electron injection layer may contain the polymer binder described above. The thickness of the electron injection layer is preferably limited to 10 to 200 nm, more preferably 20 to 80 nm. When the electron injection layer is thinner than 200 nm, a rise in driving voltage can be inhibited. Meanwhile, when the electron injection layer is thicker than 10 nm, the electroluminescent device can be protected against short-circuiting.

### (F) Hole injection layer

If necessary, the electroluminescent device of the present invention may have a hole injection layer formed of the hole injecting material described above. The hole injection layer may contain the polymer binder described above. As described above, the hole injection layer is preferably the conductive cured film of the present invention. The conductive cured film is preferably obtained by applying curing energy to a film of the conductive polymer composition. The thickness of the hole injection layer is preferably limited to 10 to 200 nm, more preferably 20 to 80 nm. When the hole injection layer is thinner than 200 nm, a rise in driving voltage can be inhibited. Meanwhile, when the hole injection layer is thicker than 10 nm, the electroluminescence device can be protected against short-circuiting.

### (G) Others

The electroluminescence device of the present invention may have one of the protective layers described, for example, in Japanese Patent Application Laid-Open Nos. Hei 7-85974, Hei 7-192866, Hei 8-22891, Hei 10-275682 and Hei 10-106746. The protective layer is formed on the uppermost surface of the electroluminescence device. In the case of an electroluminescence device fabricated by laminating a substrate, a transparent electrode, an organic layer and a back electrode in this order, the uppermost surface of the electroluminescence device indicates the outer surface of the back electrode. In the case of an electroluminescence device fabricated by laminating a substrate, a back electrode, an organic layer and a transparent electrode in this order, the uppermost surface of the electroluminescence device indicates the outer surface of the transparent electrode. The shape, size, thickness, etc. of the protective layer are not particularly limited. Any material may be used to form the protective layer so long as it has the ability to inhibit harmful factors (e.g., moisture and oxygen) deteriorating the functions of the electroluminescence device from entering or permeating the device. Examples of suitable materials for the protective layer include silicon monoxide, silicon dioxide, germanium monoxide and germanium dioxide.

The protective layer may be formed by any suitable method, for example, vacuum deposition, sputtering, reactive sputtering, molecular beam epitaxy, cluster ion beam, ion plating, plasma polymerization, plasma CVD, laser CVD, thermal CVD or coating.

### <Sealing>

The electroluminescence device of the present invention may have a sealing layer to prevent permeation of moisture and oxygen. Examples of materials for the sealing layer include copolymers of tetrafluoroethylene and one or more comonomers, fluorine-containing copolymers having a cyclic structure in the main chain thereof, polyethylene, polypropylene, polymethyl methacrylate, polyimide, polyurea, polytetrafluoroethylene, polychlorotrifluoroethylene, polydichlorodifluoroethylene, copolymers of chlorotrifluoroethylene and other comonomers, copolymers of dichlorodifluoroethylene and other comonomers, moisture-absorbing materials having a water absorption rate of 1% or more, moisture-proofing materials having a water absorption rate of 0.1% or less, metals (for example, In, Sn, Pb, Au, Cu, Ag, Al, Ti and Ni), metal oxides (for example, MgO, SiO, SiO₂, Al₂O₃, GeO, NiO, CaO, BaO, Fe₂O₃, Y₂O₃ and TiO₂), metal fluorides (for example, MgF₂, LiF, AlF₃ and CaF₂), liquid fluorinated carbons (for example, perfluoroalkanes, perfluoroamines and perfluoroethers), and dispersions of a moisture or oxygen adsorbent in the liquid fluorinated carbons.

The organic electroluminescence device of the present invention can emit light when a direct current voltage (which may include an alternating current component as required) of typically 2-15 V or a direct current is applied between the anode and the cathode.

The organic electroluminescence device of the present invention may be driven by the methods described, for example, in Japanese Patent Application Laid-Open Nos. Hei 2-148687, Hei 6-301355, Hei 5-29080, Hei 7-134558, Hei 8-234685 and Hei 8-241047, Japanese Patent No. 2784615 and U.S. Patent Nos. 5828429 and 6023308.

### EXAMPLES

The present invention will be explained in more detail with reference to the following examples. Those skilled in the art may appropriately select materials, reagents, amounts and ratios thereof, operations, etc. shown in the following examples without departing from the spirit of the invention. Therefore, it should be understood that the scope of the present invention is not limited by the examples in any manner.

### (Preparation of Coating Solutions for Hole injection layers E1-E4 and R1)

60 g of Nafion (registered trademark) (DE521), which is an aqueous colloidal dispersion (5.0%), 240 g of deionized water and 1.0 g of sodium persulfate were weighed and placed in a 500 mL separable flask. The mixture was stirred for 1 hr under a flow of N₂. To the mixture were added 350 µg of iron (III) sulfate n-hydrate (091-02832, made by Wako Pure Chemical Industries, Ltd.) and 1.5 g of 3,4-ethylenedioxythiophene. Stirring was continued for 4 hour.
10 g of LEWATIT (registered trademark) S100 (LANXESS) and 10 g of LEWATIT (registered trademark) MP62WS (LANXESS) as ion exchange resins were added. After stirring for 1 hour, the reaction was stopped. The two ion exchange resins were separately washed with deionized water until no color was visible in water before use.
The ion exchange resins were separated off by filtration, an aqueous dispersion of poly(3,4-ethylenedioxyhiophene) (PEDOT)/Nafion was obtained.

1N hydrochloric acid was added to the aqueous dispersion, followed by centrifugation. The solid was collected. Deionized water was added to the solid, followed by centrifugation to collect a slurry containing poly(3,4-ethylenedioxythiophene) (PEDOT) and an acid polymer (hereinafter, also referred to as "fluorinated polymer 1"). The fluorinated polymer 1 corresponds to the first polymer.

The slurry and a non-aqueous solvent (a mixture of isopropanol and ethylene glycol (9:1)), which had been previously dehydrated using molecular sieves (3A 1/8, made by Wako Pure Chemical Industries, Ltd.), were mixed with the curing agents as shown in Table 1 to prepare coating solutions for hole injection layers E1-E3 and R1. Each of the coating solutions had a solids content of 20% by mass.
The slurry, a non-aqueous solvent (a mixture of isopropanol and ethylene glycol (9:1)), which had been previously dehydrated using molecular sieves (3A 1/8, made by Wako Pure Chemical Industries, Ltd.), and an aqueous solution of polyvinyl alcohol (PVA-217, made by Kuraray Co., LTD; solid content = 10% by mass) were mixed to prepare a coating solution for a hole injection layer E4. The coating solution had a solids content of 20% by mass.
The components and the total solids contents of the coating solutions E1-E4 and R1 with respect to the total solids content of each coating solution are shown in Table 1.

**[TABLE 1]**

| Coating solution | Conductive polymer | | Acid polymer | | Curing agent | |
|---|---|---|---|---|---|---|
| | Kind | Content | Kind | Content | Kind | Content |
| E1 | PEDOT | 33.28 | Fluorinated polymer 1 | 66.57 | Phenethyltrimethoxysilane | 0.15 |
| E2 | PEDOT | 33.28 | Fluorinated polymer 1 | 66.57 | Ethyltrimethoxysilane | 0.15 |
| E3 | PEDOT | 33.28 | Fluorinated polymer 1 | 66.57 | 3-glycidoxypropyltrimethoxysilane | 0.15 |
| E4 | PEDOT | 29.95 | Fluorinated polymer 1 | 59.91 | Polyvinyl alcohol | 10.14 |
| R1 | PEDOT | 33.3 | Fluorinated polymer 1 | 66.7 | - | 0 |

The content of each component was expressed as the concentration (% by mass) of the component with respect to the total solids content of each coating solution for hole injection layer.

### (Coating Solution for Hole injection layer R2)

10% by mass of isopropanol was added to an aqueous dispersion of PEDOT/PSS (1.2% by mass) (CLEVIOS AI P 4083, made by CLEVIOS) to prepare a coating solution for a hole injection layer R2. The concentrations of poly(3,4-ethylenedioxythiophene) (PEDOT) and poly(styrenesulfonate (PSS) with respect to the total solids content of the coating solution R2 were 14.3% by mass and 85.7% by mass, respectively. No curing agents were included in the coating solution R2.

### (Preparation of Coating Solution for Light-emitting Layer 1)

0.15% by mass of Ir(ppy)₃ as an indium complex, 2.85% by mass of Compound 1 and 97% by mass of NMP/2-n-butoxyethanol (6/4, w/w) as a solvent were mixed to prepare a coating solution for a light-emitting layer 1.

### (Preparation of Coating Solution 2 for Light-emitting Layer)

0.45% by mass of Compound 2 as an iridium complex, 2.55% by mass of Compound 3 and 97% by mass of toluene as a solvent were mixed to prepare a coating solution for a light-emitting layer 2.

### (Preparation of Coating Solution for Hole injection layer E5)

60 g of Nafion (registered trademark) (DE520), which is an aqueous colloidal dispersion (5.0% by mass), 240 g of deionized water and 1.0 g of sodium persulfate were weighed and placed in a 500 mL separable flask. The mixture was stirred for 1 hour under a flow of N₂. To the mixture were added 350 µg of iron (III) sulfate n-hydrate (091-02832, made by Wako Pure Chemical Industries, Ltd.), 1.2 g of 3,4-ethylenedioxythiophene and 0.3 g of pyrrole. Stirring was continued for 4 hour.
109 of LEWATIT (registered trademark) S100 (LANXESS) and 109 of LEWATIT (registered trademark) MP62WS (LANXESS) as ion exchange resins were added. After stirring for 1 hour, the reaction was stopped. The two ion exchange resins were separately washed with deionized water until no color was visible in water before use.
The ion exchange resins were separated off by filtration, an aqueous dispersion of poly(3,4-ethylenedioxythiophene/pyrrole)/Nafionwasobtained.

1 N hydrochloric acid was added to the aqueous dispersion, followed by centrifugation. The solid was collected. Deionized water was added to the solid, followed by centrifugation to collect a slurry containing poly(3,4-ethylenedioxythiophene/pyrrole) and an acid polymer (hereinafter, also referred to as "fluorinated polymer 2"). The fluorinated polymer 2 corresponds to the first polymer.

The slurry, phenethyltrimethoxysilane and a non-aqueous solvent (a mixture of isopropanol and ethylene glycol (9:1)), which had been previously dehydrated using molecular sieves (3A 1/8, made by Wako Pure Chemical Industries, Ltd.), were mixed to prepare a coating solution for a hole injection layer E5. The coating solution had a solids content of 20% by mass.

### (Preparation of Coating Solution for Hole injection layer E6)

60 g of Nafion (registered trademark) (DE520), which is an aqueous colloidal dispersion (5.0%), 240 g of deionized water and 1.0 g of sodium persulfate were weighed and placed in a 500 mL separable flask. The mixture was stirred for 1 hr under a flow of N₂. To the mixture were added 350 µg of iron (III) sulfate n-hydrate (091-02832, Wako Pure Chemical Industries, Ltd.), 1.2 g of 3,4-ethylenedioxythiophene and 0.3 g of thiophene. Stirring was continued for 4 hour.
10 g of LEWATIT (registered trademark) S100 (LANXESS) and 10 g of LEWATIT (registered trademark) MP62WS (LANXESS) as ion exchange resins were added. After stirring for 1 hour, the reaction was stopped. The two ion exchange resins were separately washed with deionized water until no color was visible in water before use.
The ion exchange resins were separated off by filtration, an aqueous dispersion of poly(3,4-ethylenedioxythiophene/thiophene)/Nafion was obtained.

1 N hydrochloric acid was added to the aqueous dispersion, followed by centrifugation. The solid was collected. Deionized water was added to the solid, followed by centrifugation to collect a slurry containing poly(3,4-ethylenedioxythiophene/thiophene) and an acid polymer (fluorinated polymer 2).

The slurry, phenethyltrimethoxysilane and a non-aqueous solvent (a mixture of isopropanol and ethylene glycol (9:1)), which had been previously dehydrated using molecular sieves (3A 1/8, made by Wako Pure Chemical Industries, Ltd.), were mixed to prepare a coating solution for a hole injection layer E6.

The components and the total solids contents of the coating solutions E5 and E6 with respect to the total solids content of each coating solution are shown in Table 1.

**[TABLE 2]**

| Coating solution | Conductive polymer | | Acid polymer | | Curing agent | |
|---|---|---|---|---|---|---|
| | Kind | Content | Kind | Content | Kind | Content |
| E5 | Poly(3,4-ethylenedioxy thiophene/pyrrole) | 33.28 | Fluorinated polymer 2 | 66.57 | Phenethyltrimethoxysilane | 0.15 |
| E6 | Poly(3,4-ethylenedioxy thiophene/thiophene) | 33.28 | Fluorinated polymer 2 | 66.57 | Phenethyltrimethoxysilane | 0.15 |

The content of each component was expressed as the concentration (% by mass) of the component with respect to the total solids content of the corresponding coating solution.

### <Example 1>

ITO was deposited to a thickness of 150 nm on a glass substrate of 25 mm ×25 mm × 0.7 mm to form a transparent support substrate. The transparent support substrate was etched and washed.
The coating solution E1 was spin-coated on the ITO-deposited glass substrate, placed on a hot plate at 100°C for 10 min, and dried in an oven at 150 °C for 30 min to form a hole injection layer (thickness = about 40 nm).
The coating solution 1 for light-emitting layer was spin-coated on the hole injection layer to form a light-emitting layer (thickness = about 40 nm).
Subsequently, BAlq was deposited to a thickness of 40 nm on the light-emitting layer by vacuum deposition to form an electron injection layer.
Lithium fluoride was deposited to a thickness of 1 nm on the electron injection layer, and aluminum was deposited to a thickness of 70 nm to form a cathode.
The resulting laminate was placed in a glove box introduced with argon gas, and sealed using a sealing can made of stainless steel and a UV curable adhesive (XNR5516HV, made by Nagase Chiba, Co., Ltd.), completing the fabrication of an organic electroluminescence device.

### <Example 2>

An organic electroluminescence device was fabricated in the same manner as in Example 1, except that the coating solution E1 was changed to the coating solution E2.

### <Example 3>

An organic electroluminescence device was fabricated in the same manner as in Example 1, except that the coating solution E1 was changed to the coating solution E3.

### <Example 4>

An organic electroluminescence device was fabricated in the same manner as in Example 1, except that the coating solution E1 was changed to the coating solution E4.

### <Example 5>

An organic electroluminescence device was fabricated in the same manner as in Example 1, except that the coating solution 2 was used.

### <Example 6>

An organic EL device was fabricated in the same manner as in Example 1, except that the coating solution E1 was changed to the coating solution E5.

### <Example 7>

An organic EL device was fabricated in the same manner as in Example 1, except that the coating solution E1 was changed to the coating solution E6.

### <Comparative Example 1>

An organic electroluminescence device was fabricated in the same manner as in Example 1, except that the coating solution E1 was changed to the coating solution R1.

### <Comparative Example 2>

An organic electroluminescence device was fabricated in the same manner as in Example 1, except that the coating solution E1 was changed to the coating solution R2.

### <Comparative Example 3>

An organic electroluminescence device was fabricated in the same manner as in Comparative Example 1, except that the coating solution 2 was used.

The compounds used in the fabrication of the organic electroluminescence devices of Examples and Comparative Examples are as follows.

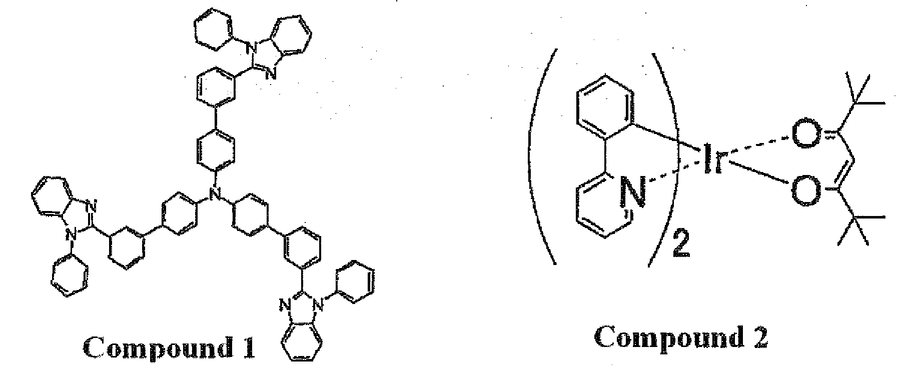

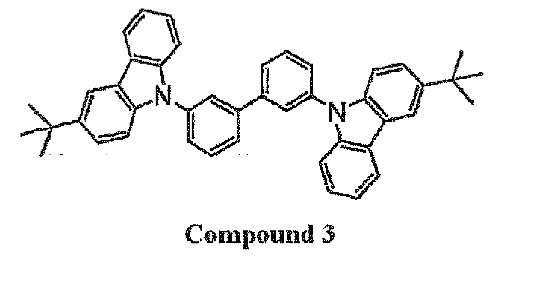

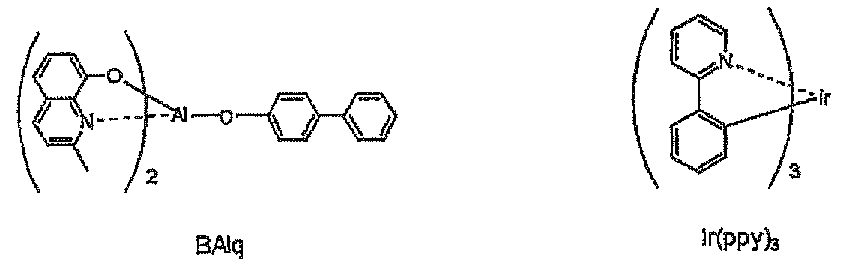

### (Performance Evaluation)

### (1) Solvent Resistance

A change in the thickness of each of the hole injection layers before and after coating of the light-emitting layer was measured using a contact type stylus surface profilometer (XP-200, manufactured by AMBiOS Technology, Inc.) The results are shown in Table 3. The solvent resistance was evaluated based on the following criteria.
A: No change in the thickness of the hole injection layer was observed
B: Dissolution or thickness reduction of the hole injection layer was observed

### (2) Durability

The organic electroluminescence devices were continuously driven at an initial luminance of 500 cd/m² while applying a constant current to the devices at room temperature. The time when the luminance of the organic electroluminescence device of Example 1 decreased to half of its initial value was measured. A comparison was made based on the organic electroluminescence device of Example 1. The results are shown in Table 3. The durability was evaluated based on the following criteria.
A: Greater than or equal to the time when the luminance of the organic electroluminescence device of Example 1 decreased to half of its initial value
B: 0.5 times greater than but less than the time when the luminance of the organic electroluminescence device of Example 1 decreased to half of its initial value
C: Less than 0.5 times the time when the luminance of the organic electroluminescence device of Example 1 decreased to half of its initial value

### (Evaluation Results)

The results are shown in Table 3.

**[TABLE 3]**

| | | Solvent resistance | Durability |
|---|---|---|---|
| Example No. | 1 | A | A |
| | 2 | A | A |
| | 3 | A | A |
| | 4 | A | B |
| | 5 | A | A |
| | 6 | A | A |
| | 7 | A | A |
| Comparative Example No. | 1 | B | C |
| | 2 | A | C |
| | 3 | A | C |

As can be seen from the evaluation results, the organic electroluminescence devices of Examples 1-7 showed high solvent resistance and high durability. Particularly, the organic electroluminescence devices of Examples 1-3 and 5-7, each of which used the silicon compound represented by Si(R¹)₃(R²), had higher durability because the non-aqueous solvent composed large portions of the solvents of the coating solutions for hole injection layers (i.e. the amount of water in the coating solutions was very small).

### <Measurement of thickness profiles of Ir and F elements>

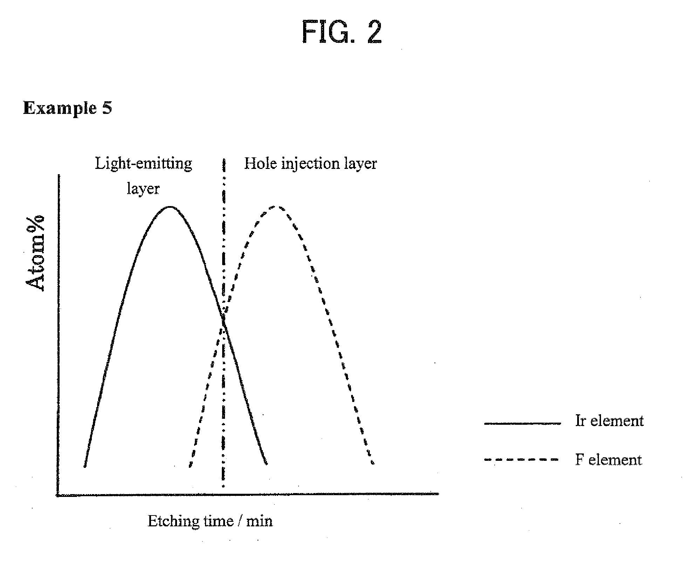

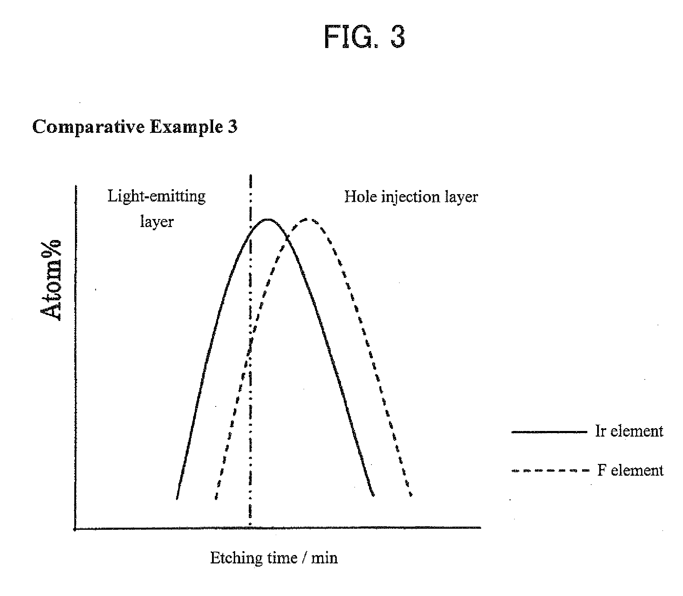

The thickness profiles of Ir and F elements in the organic electroluminescence devices of Example 5 and Comparative Example 3 were measured using an X-ray photoelectron spectrometer (ESCA-XPS).
Specifically, changes in the contents of Ir and F elements in the hole injection layer and light-emitting layer of each of the organic electroluminescence devices fabricated in Examples 5 and Comparative Example 3 in the thickness directions of the layers (thickness profiles) were measured using an X-ray photoelectron spectrometer (SSX-100, manufactured by Surface Science Instruments). The obtained profiles are shown in Figs. 2 and 3.
In each of Figs. 2 and 3, the interface between the light-emitting layer and the hole injection layer is indicated by the alternate long and two short dashed line.
The peaks of the profiles (x 50 magnifications) of Ir and F elements in the organic electroluminescence device of Example 5 are separated from each other. In contrast, the peaks of the profiles of Ir and F element in the organic electroluminescence device of Comparative Example 3 are located close to each other, suggesting a mixed state of the light-emitting layer and the hole injection layer.
From these results, it was confirmed that the hole injection layer, which corresponds to the conductive cured film obtained using the conductive polymer composition of the present invention, can be prevented from mixing with the light-emitting layer, and has improved resistance to organic solvents.

### <Example 8>

### (Preparation of Coating Solution for Light-emitting Layer A)

0.15% by mass of Firpic as an iridium complex, 2.85% by mass of Compound 4 and 97% by mass of 2-butanone as a solvent were mixed to prepare a coating solution for a light-emitting layer A.

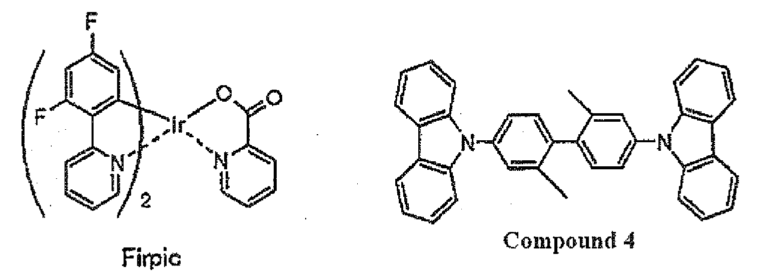

### (Fabrication of Organic electroluminescence device)

An organic electroluminescence device A was fabricated in the same manner as in Example 1, except that the coating solution A was used. As a result of applying an electric current to the device, light blue electroluminescence was observed.

### <Example 9>

### (Preparation of Coating Solution for Light-emitting Layer B)

0.15% by mass of Compound 5 as an indium complex, 2.85% by mass of Compound 6 and 97% by mass of toluene as a solvent were mixed to prepare a coating solution for a light-emitting layer B.

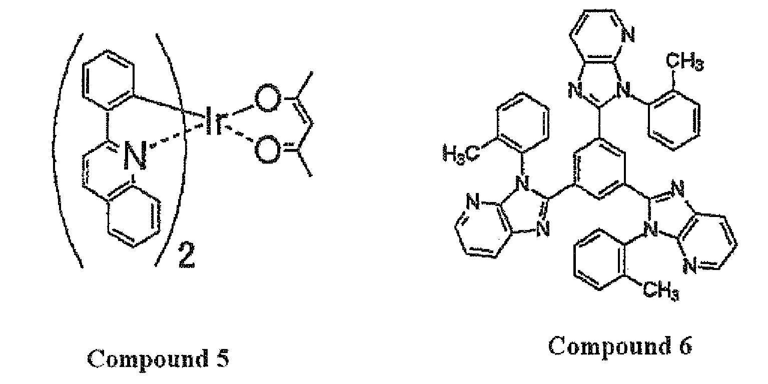

### (Fabrication of Organic electroluminescence device)

An organic electroluminescence device B was fabricated in the same manner as in Example 1, except that the coating solution B was used. As a result of applying an electric current to the device, red electroluminescence was observed.

### <Example 10>

### (Preparation of Coating Solution for Light-emitting Layer C)

0.15% by mass of Compound 7 as an iridium complex, 2.85% by mass of Compound 8 and 97% by mass of 2-butanone as a solvent were mixed to prepare a coating solution for a light-emitting layer C.

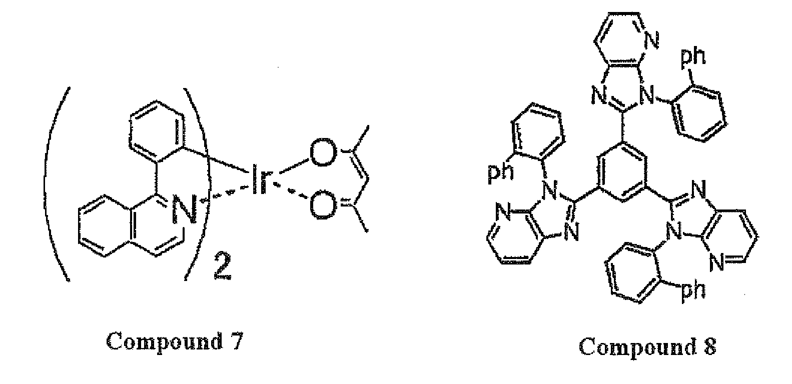

### (Fabrication of Organic electroluminescence device)

An organic electroluminescence device C was fabricated in the same manner as in Example 1, except that the coating solution C was used. As a result of applying an electric current to the device, red electroluminescence was observed.

### INDUSTRIAL APPLICABILITY

The conductive polymer composition of the present invention can form a conductive film that has high resistance to organic solvents and can ensure excellent durability (i.e. having a long lifespan of luminance half-life) of an electroluminescent device.
In addition, the conductive cured film of the present invention has high resistance to organic solvents and can ensure excellent durability of an electroluminescent device.
Furthermore, the organic electroluminescence device of the present invention has excellent durability (i.e. having a long lifetime of luminance half-life).

While the invention has been described in detail with reference to specific embodiments thereof, it will be apparent to those skilled in the art that various modifications and variations can be made in the present invention without departing from the spirit and scope of the present invention.
This application is based on Japanese Patent Application No. 2009-083774 filed on March 30, 2009, the contents of which are herein incorporated by reference.

### EXPLANATION OF REFERENCE NUMERALS

| | |
|---|---|
| 1: Substrate | 2: Transparent electrode |
| 3: Organic layer | 4: Back electrode |
| 5: Transparent electrode lead | 6: Back electrode lead |
| 7: Light-emitting laminate | 8: Sealant (adhesive) |
| 9: Sealing member | 10: Space |

## Claims

1. A conductive polymer composition comprising:
(A) a conductive polymer;
(B) a first polymer comprising a repeating unit represented by Formula (1) as indicated below and a repeating unit represented by Formula (II) as indicated below, or
a second polymer comprising a repeating unit represented by Formula (I) as indicated below, a repeating unit represented by Formula (II) as indicated below and a repeating unit represented by Formula (II') as indicated below: 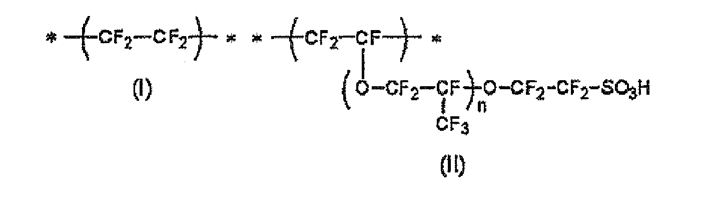 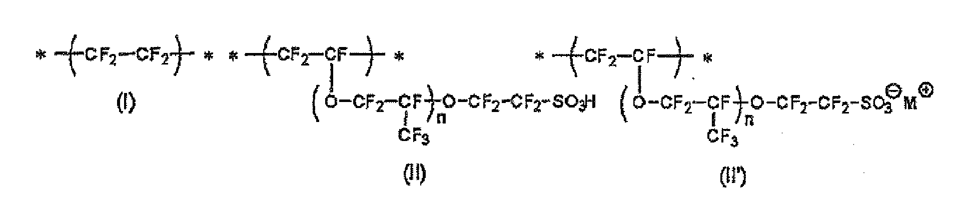 wherein M⁺ represents a monovalent cation and each n independently represents an integer, and
(C) a curing agent.

2. The conductive polymer composition according to claim 1,
wherein the conductive polymer is a polymer or copolymer of one or more monomers selected from the group consisting of thiophene, thiophene derivatives, pyrrole and pyrrole derivatives.

3. The conductive polymer composition according to claim 1 or 2,
wherein the curing agent is a silicon compound represented by Si(R¹)₃(R²):
wherein each R¹ independently represents a C₁-C₅ alkoxy group and R² represents a monovalent hydrophobic group.

4. The conductive polymer composition according to claim 1 or 2,
wherein the curing agent is a polyhydric alcohol.

5. The conductive polymer composition according to any one of claims 1 to 4, further comprising (D) a solvent.

6. The conductive polymer composition according to claim 5,
wherein the solvent is a non-aqueous solvent.

7. The conductive polymer composition according to claim 6,
wherein the non-aqueous solvent is pretreated with dehydration or column purification.

8. A conductive cured film obtained by applying curing energy to a film of the conductive polymer composition according to any one of claims 1 to 7.

9. An organic electroluminescence device comprising one or more organic layers wherein one of the organic layers is the conductive cured film according to claim 8.

10. The organic electroluminescence device according to claim 9, wherein one of the organic layers is a hole injection layer.
